# EUROPEAN PATENT APPLICATION

(11) **EP 1 793 496 A2**
(43) Date of publication of application: **06.06.2007**
(21) Application number: 06077098.9
(22) Date of filing: 24.11.2006
(51) Int. Cl.: H03K 17/082

(54) **Short circuit protection for vehicle driver circuit**

(30) Priority: 05.12.2005 US 293930
(71) Applicant: Delphi Technologies, Inc., Troy, Michigan 48007 (US)
(72) Inventor: Lin, Yingjie, El Paso, TX 79912 (US); Sanchez, Manuel S., 32674 Juarez, Chihuahua (MX)
(74) Representative: Denton, Michael John

(57) **Abstract**

A control circuit for a vehicle for, e.g., chassis leveling or other purposes includes a controller (12) selectively sending drive signals to a load (14) through a switch FET (M1), and a BJT having a collector connected between the switch FET (M1), an emitter connected to ground, and a base connected to a current view resistor for short circuit protection. An over power protection FET (M2) is connected to the controller (12) and to the base of the short circuit protection transistor (Q1), with the gate of the over power protection FET (M2) being connected to the output of the switch FET (M1). A time delay capacitor is connected from the base of the BJT to ground. With this structure, if a ground fault causes the BJT to turn on, and if the drain-source voltage of the switch FET (M1) exceeds the gate threshold voltage of the overpower protection FET, the overpower protection FET is turned on, resulting in turning off the switch FET (M1) and, hence, avoidance of high power draw through the switch FET (M1).

## Description

### TECHNICAL FIELD

The present invention relates generally to short circuit protection for vehicle driver circuits.

### BACKGROUND OF THE INVENTION

Modem vehicles have many control systems in which a controller, in response to sensor signals, actuates vehicle components to control the vehicle. As one illustration, a chassis levelling controller might receive input from various sensors and in response turn "on" and "off" a relay to control a compressor or to energize and deenergize the solenoid of a relief valve as needed to increase or decrease pressure in a vehicle's shock absorbers. Components to be selectively energized, such as relays and solenoids, may be referred to as "loads".

Regardless of the application, the actuation signals typically are sent through a driver circuit, and a driver circuit ordinarily includes a switch that is turned on and off by the controller to send (or not send) the actuation signals. Field effect transistors (FET) are commonly used solid state devices that can be used as a switches, with the controller establishing the gate voltage of the FET as appropriate to turn the FET "on" and "off".

Under some circumstances such as during maintenance, it happens that the "load" circuit might unintentionally be shorted, shorting the battery power directly to ground through the switch and driver if the controller attempts to energize the load. This failure can generate very high currents through the driver and associated wiring harness, potentially damaging the FET or harness or both. To prevent such damage short circuit protection to limit current draw is provided.

A common way to do this is to place a low resistance "current view" resistor between the source of the FET and ground. The base and emitter of a bipolar junction transistor (BJT) are placed across the current view resistor, with the collector of the BJT being connected to the gate of the FET. The value of the current view resistor is established such that an over current condition generates sufficient voltage drop across the resistor to turn on the BJT, decreasing the voltage between its collector and emitter and thus lowering the gate-source voltage of the FET. In turn, the drain-source resistance of the FET increases, thereby reducing the load current and thus limiting the load current.

As understood herein, however, an unfortunate trade off with this design is that while it is effective in providing short circuit protection, the FET must be able to survive very high power consumption should a short circuit occur, increasing the cost and size of the FET. With this critical recognition in mind, the invention herein is provided.

### SUMMARY OF THE INVENTION

A circuit for a control system of a vehicle includes a controller, a load energizable to actuate a vehicle component, and a switch, which can be a solid state switch such as a FET, between the load and controller and controlled by the controller to selectively send a drive signal to the load. An over power protection component is connected to the controller and to a short circuit protection transistor.

The over power protection component, which can be a FET, can be connected to the base of the short circuit protection transistor. Also, the gate of the over power protection FET can be connected to the output of the switch FET. If a load short circuit occurs it causes the over current protection transistor to turn on, decreasing the gate-source voltage of the switch FET and thus increasing the drain-source voltage of the switch FET. If the drain-source voltage of the switch FET exceeds the gate threshold voltage of the overpower protection FET, the overpower protection FET is turned on, resulting in completely turning off the switch FET.

In another aspect, in a vehicle control circuit including a controller, a load, and a switch FET therebetween, a combination is disclosed that includes means for protecting the circuit in the event of a load short circuit fault, and means for turning off the switch FET when a load short fault is present if power through the switch FET exceeds a threshold.

In still another aspect, a circuit for a vehicle includes a controller selectively sending drive signals to a load through a switch FET, and a short circuit protection transistor having a collector connected between the switch FET, an emitter connected to ground, and a base connected to a line. An over power protection FET is connected to the controller and to the base of the short circuit protection transistor.

The details of the present invention, both as to its structure and operation, can best be understood in reference to the accompanying drawings, in which like reference numerals refer to like parts, and in which:

### BRIEF DESCRIPTION OF THE DRAWINGS

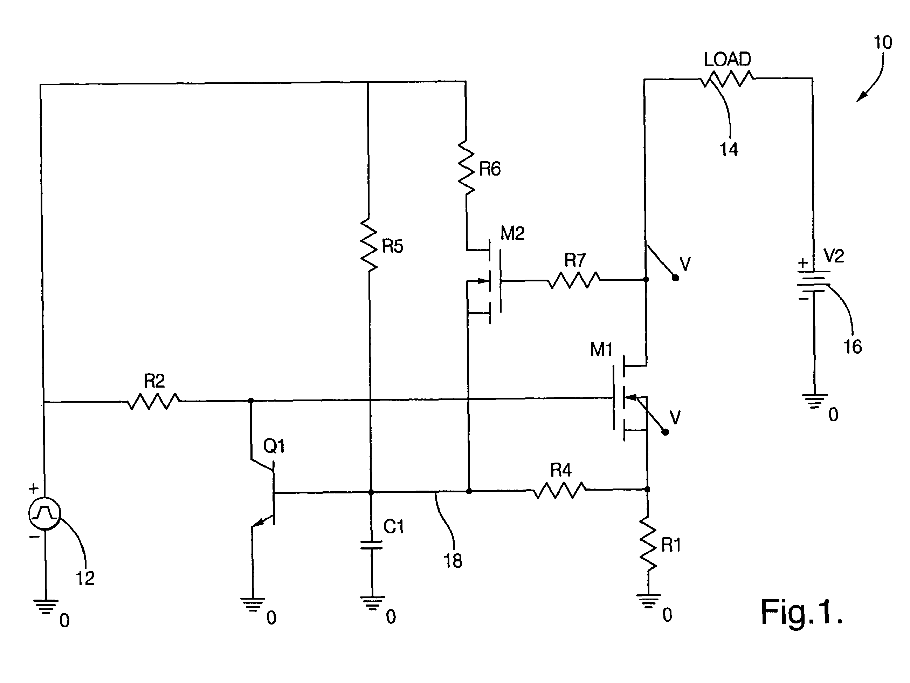

The Figure is a schematic diagram of the present circuit.

### DESCRIPTION OF THE PREFERRED EMBODIMENT

The present invention is intended for application in automotive vehicle suspension systems and will be described in that context. It is to be understood, however, that the present invention could also be successfully applied in many other applications.

The Figure shows a circuit, generally designated 10, which includes a controller 12 that can be implemented by a microcontroller or other digital processing system and a load 14 that can receive power from a vehicle electrical system source 16 (e.g., the battery and/or alternator). The controller 12 sends driver signals to the load 14 to actuate the load 14. By way of non-limiting example, the load 14 may be a relay which, when energized, causes a compressor to be activated to increase air pressure in a shock absorber, or the load 14 can be the solenoid of a relief valve, or other load in any vehicle control system.

The controller 12 actuates the load 14 by sending driver signals through a switch M1. In one embodiment the switch M1 is a FET, the gate voltage of which is established by the controller 12 as necessary to open or close the FET. In non-limiting implementations the FET is a type mmdf4n01d FET and a 10K Ohm resistor R2 is placed in series between the controller 12 and FET.

Short circuit protection is provided by a short circuit protection transistor Q1 which may be a type Q2N3904 type BJT transistor. The collector of the short circuit protection transistor Q1 can be connected between the resistor R2 and switch M1 and the emitter can be connected to ground as shown, with the base of the short circuit protection transistor Q1 being connected to a line 18. A first short circuit protection resistor R4 is in the line 18, and the line 18 is grounded as shown through a second short circuit protection resistor R1, which may also be considered a "current view" resistor. The line 18 is also grounded through a time delay capacitor C1 in parallel with the short circuit protection resistors R1, R4 as shown.

The value of R1 is determined by the current limitation of the driver. In non-limiting implementations, the R1 value preferably is established so that the voltage across the resistor R1 under maximum allowed current is in the range from 0.3 to 0.6 volts. Voltage divider resistors R5 with R4 series R1 form a voltage divider circuit to the BJT base. The resistor R5 and R4 values are selected so that under normal operational conditions (load current less than the maximum current limitation), the base voltage is less than 0.7 volts. In non-limiting implementations the time delay capacitor C1 may have a capacitance of ten nanoFarads. The function of the time delay capacitor is to hold the BJT base voltage low for short periods of time at the beginning of the control signal to turn on the switch FET. This enables the switch FET to be always turned on at very beginning. The time delay capacitor C1 then is charged through the voltage divider resistor R5. The time delay (the charging time of the capacitor C1) is determined by the time constant of R5 and C1. After the capacitor C1 is fully changed, if the load current is within the limitation, the BJT is not on, and the switch FET will remain on. In contrast, if the load current is over the limitation, the BJT is on and the protection circuit then kicks in to turn off the switch FET.

After the protection circuit turns off the switch FET, the circuit is self-locked at the OFF status even after the short circuit fault has been removed. The protection circuit resets itself after the controller turns the driver signal off.

The over current protection transistor BJT also could be replaced by a FET. In this case, the turn on voltage should be changed from 0.7 volts to the gate-source threshold voltage.

Turning now to the feature which facilitates the use of a relatively small and inexpensive FET as the switch M1, an over power protect component M2 is connected through a first overpower protect resistor R6 to the controller 12, and to the base of the short circuit protection transistor Q1 via the line 18. The over power protection component M2 may be a FET, and in some implementations can be a type M2N7000 FET whose gate is connected, through a gate resistor R7, to the output of the switch M1. A parallel resistor R5 may be placed as shown between the controller 12 and the base of the short circuit protection transistor Q1, in parallel with the overpower protection component M2. In non-limiting implementations the first overpower protect resistor R6 can be a 20KOhm resistor, the gate resistor R7 can be a 100KOhm resistor, and the parallel resistor R5 can be a 20KOhm resistor.

With the above combination of structure, in the event of a ground fault which causes the over current protection transistor Q1 to turn on, the circuit is protected, and the gate-source voltage of the switch M1 drops, resulting in less current to the load 14, which would otherwise cause an undesirable increase in the power consumed by the switch M1. However, owing to the overpower protection component M2, once the drain-source voltage of the switch M1 exceeds the gate threshold voltage of the overpower protection component M2, the overpower protection component is turned on, resulting in fully turning on the short circuit protection transistor Q1 and turning off the switch M1, both protecting the circuit and permitting the use of a FET as the switch M1 that does not have to withstand high power.

While the particular SHORT CIRCUIT PROTECTION FOR VEHICLE DRIVER CIRCUIT as herein shown and described in detail is fully capable of attaining the above-described objects of the invention, it is to be understood that it is the presently preferred embodiment of the present invention and is thus representative of the subject matter which is broadly contemplated by the present invention, that the scope of the present invention fully encompasses other embodiments which may become obvious to those skilled in the art, and that the scope of the present invention is accordingly to be limited by nothing other than the appended claims, in which reference to an element in the singular is not intended to mean "one and only one" unless explicitly so stated, but rather "one or more". It is not necessary for a device or method to address each and every problem sought to be solved by the present invention, for it to be encompassed by the present claims. Furthermore, no element, component, or method step in the present disclosure is intended to be dedicated to the public regardless of whether the element, component, or method step is explicitly recited in the claims. Absent express definitions herein, claim terms are to be given all ordinary and accustomed meanings that are not irreconcilable with the present specification and file history.

## Claims

1. A circuit for a control system of a vehicle, comprising:
a controller (12);
a load (14) energizable to actuate a vehicle component;
a switch (M1) between the load (14) and controller (12) and controlled by the controller (12) to selectively send a drive signal to the load (14); and
an over power protection component (M2) connected to the controller (12) and to a short circuit protection transistor (Q1).

2. The system of Claim 1, wherein the over power protection component (M2) is connected to the base of the short circuit protection transistor (Q1).

3. The system of Claim 1, wherein the over power protection component (M2) is an over power protection FET, and the switch (M1) is a switch FET.

4. The system of Claim 3, wherein the gate of the over power protection FET is connected to the output of the switch FET.

5. The system of Claim 4, wherein a fault causes the short circuit protection transistor to turn on, and if the drain-source voltage of the switch FET exceeds the gate threshold voltage of the overpower protection FET, the overpower protection FET is turned on, resulting in turning off the switch FET.

6. In a vehicle control circuit including a controller (12), a load (14), and a switch FET (M1) therebetween, a combination comprising:
means (Q1) for protecting the circuit in the event of a short circuit; and
means (M2) for turning off the switch FET (M1) when a short circuit is present if power through the switch FET (M1) exceeds a threshold.

7. The circuit of Claim 6, wherein the means for protecting includes a short circuit protection transistor (Q1).

8. The circuit of Claim 7, wherein the means for turning off includes an overpower protection FET (M2).

9. The circuit of Claim 8, wherein the over power protection FET (M2) is connected to the controller (12) and to the short circuit protection transistor (Q1).

10. The circuit of Claim 9, wherein the over power protection FET (M2) is connected to the base of the short circuit protection transistor (Q1).

11. The circuit of Claim 10, wherein the gate of the over power protection FET (M2) is connected to the output of the switch FET (M1).

12. The circuit of Claim 11, wherein a short circuit causes the short circuit protection transistor to turn on, and if the drain-source voltage of the switch FET (M1) exceeds the gate threshold voltage of the overpower protection FET, the overpower protection FET is turned on, resulting in turning off the switch FET (M1).

13. A circuit for a vehicle, comprising:
at least one controller (12) selectively sending drive signals to at least one load (14) through a switch FET (M1);
at least one short circuit protection transistor (Q1) having a collector connected to the switch FET (M1), an emitter connected to ground, and a base; and
at least one over power protection FET (M2) connected to the controller (12) and to the base of the short circuit protection transistor (Q1).

14. The circuit of Claim 13, wherein the gate of the over power protection FET (M2) is connected to the output of the switch FET (M1).

15. The circuit of Claim 14, wherein a short circuit causes the short circuit protection transistor to turn on, and if the drain-source voltage of the switch FET (M1) exceeds the gate threshold voltage of the overpower protection FET, the overpower protection FET is turned on, resulting in turning off the switch FET (M1).
